# EUROPÄISCHE PATENTSCHRIFT

(11) **EP 2 405 728 B1**
(45) Veröffentlichungstag und Bekanntmachung des Hinweises auf die Patenterteilung: **01.03.2017**
(21) Anmeldenummer: 11172308.6
(22) Anmeldetag: 01.07.2011
(51) Int. Cl.: H05K 5/02, H05K 5/00, H05K 7/14

(54) **Steuerungseinrichtung**
Control device
Dispositif de commande

(30) Priorität: 08.07.2010 DE 102010026593
(43) Veröffentlichungstag der Anmeldung: 11.01.2012
(73) Patentinhaber: Honeywell Technologies Sarl, 1180 Rolle (CH)
(72) Erfinder: Hohpe, Norbert, 71083 Herrenberg (DE); Stobbe, Waldemar, 71034 Böblingen (DE)
(74) Vertreter: Sturm, Christoph

(56) Entgegenhaltungen:
- DE-A1- 19 737 524
- DE-U1- 8 009 715
- DE-U1- 29 706 551
- US-A1- 2005 016 115
- US-A1- 2007 169 953

## Beschreibung

Die Erfindung betrifft eine Steuerungseinrichtung nach dem Oberbegriff des Anspruchs 1.

Steuerungseinrichtungen, wie zum Beispiel Regler für Heizung, Lüftung, Fernwärme und dergleichen, müssen in Tragstrukturen, so zum Beispiel an Tragwänden, befestigt werden. Bislang ist die Befestigung von Steuerungseinrichtungen an Tragstrukturen aufwendig, da hierzu spezielle Werkzeuge benötigt werden. Dies resultiert letztendlich in einer umständlichen Montage bzw. Befestigung von Steuerungseinrichtungen an Tragstrukturen.

Aus der US 2007/0169953 A1 ist eine Steuerungseinrichtung nach dem Oberbegriff des Anspruchs 1.

Aus der DE 80 09 715 U1 und DE 297 06 551 U1 sind weitere Steuerungseinrichtungen bekannt.

Der Erfindung liegt die Aufgabe zu Grunde, eine neuartige Steuerungseinrichtung zu schaffen, die einfach und sicher ohne Hilfsmittel an einer Tragstruktur befestigt werden kann.

Diese Aufgabe wird durch eine Steuerungseinrichtung gemäß Anspruch 1 gelöst.

Die Steuerungseinrichtung verfügt über einen Montagerahmen, der Befestigungsmittel bereitstellt, mithilfe derer das Gehäuse der Steuerungseinrichtung an einer Tragstruktur befestigt werden kann.

Der Montagerahmen wird hierbei mit dem Gehäuse der Steuerungseinrichtung verrastet, wobei hierzu keine Werkzeuge erforderlich sind. Ferner sind keine weiteren separaten Befestigungsmittel notwendig. Allein über den Montagerahmen ist eine Steuerungseinrichtung an einer Tragstruktur befestigbar, nämlich verrastbar.

Hierdurch wird die Montage bzw. Befestigung von Steuerungseinrichtungen an Tragstrukturen im Vergleich zum Stand der Technik deutlich vereinfacht.

Bevorzugte Weiterbildungen der Erfindung ergeben sich aus den Unteransprüchen und der nachfolgenden Beschreibung. Nachfolgend werden Ausführungsbeispiele der Erfindung, ohne hierauf beschränkt zu sein, anhand der Zeichnung näher erläutert. In der Zeichnung zeigt:
- Fig. 1: eine teilweise perspektivische Explosionsdarstellung eines ersten Ausführungsbeispiel einer erfindungsgemäßen Steuerungseinrichtung zusammen mit einer Tragstruktur;
- Fig. 2: einen Querschnitt durch die erfindungsgemäße Steuerungseinrichtung der Fig. 1 zusammen mit der Tragstruktur in einem an der Tragstruktur teilweise montiertem Zustand; und
- Fig. 3: einen Querschnitt durch eine erfindungsgemäße Steuerungseinrichtung nach einem zweiten Ausführungsbeispiel zusammen mit der Tragstruktur in einem an der Tragstruktur montiertem Zustand.

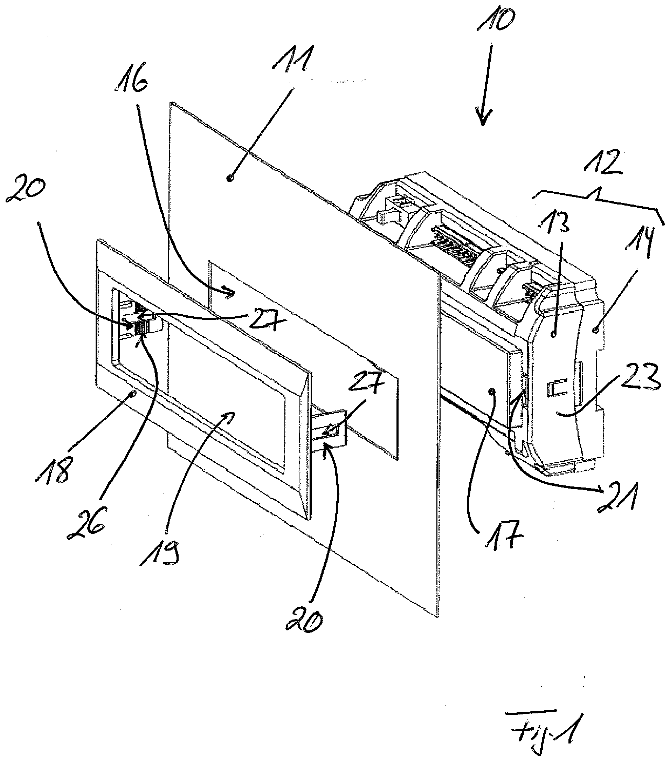

Fig. 1 zeigt eine teilweise Explosionsansicht eines ersten Ausführungsbeispiels einer erfindungsgemäßen Steuerungseinrichtung 10 zusammen mit einer Tragstruktur 11, an welcher die Steuerungseinrichtung 10 zu befestigen ist.

Die Steuerungseinrichtung 10 verfügt über ein Gehäuse 12, welches elektrische und/oder elektronische Steuerungskomponenten der Steuerungseinrichtung 10 aufnimmt, wobei im gezeigten Ausführungsbeispiel das Gehäuse 12 aus Gehäuseteilen 13 und 14 gebildet ist.

Die Gehäuseteile 13 und 14 definieren einen Innenraum 15 des Gehäuses 12, welcher der Aufnahme der elektrischen und/oder elektronischen Steuerungskomponenten der Steuerungseinrichtung 10 dient.

Die Steuerungseinrichtung 10 ist an der Tragstruktur 11 zu befestigen, wozu das Gehäuse 12 der Steuerungseinrichtung 10 von einer ersten Seite der Tragstruktur 11 aus in eine Öffnung 16 der Tragstruktur 11 eingesetzt wird, nämlich derart, dass eine am Gehäuseteil 13 des Gehäuses 12 angreifende Anzeige- und Bedieneinrichtung 17 die Öffnung 16 der Tragstruktur 11 durchdringt.

Erfindungsgemäß wird das Gehäuse 12 der Steuerungseinrichtung 10 mithilfe eines Montagerahmens 18 an der Tragstruktur 11 befestigt, nämlich derart, dass der Montagerahmen 18 von einer gegenüberliegenden, zweiten Seite der Tragstruktur 11 aus mit dem Gehäuse 12, nämlich mit dem Gehäuseteil 13 des Gehäuses 12, unter Befestigung des Gehäuses 12 an der Tragwand 11 verrastet wird.

Die Befestigung bzw. Montage der Steuerungseinrichtung 10, nämlich des Gehäuses 12 derselben, an der Tragstruktur 11 erfolgt ausschließlich über den Montagerahmen 18, der Befestigungsmittel zur Montage des Gehäuses 12 an der Tragstruktur 11 bereitstellt, sodass zur Montage des Gehäuses 12 der Steuerungseinrichtung 10 an der Tragstruktur 11 weder zusätzliche Befestigungsmittel noch Werkzeuge erforderlich sind.

In montiertem Zustand durchdringt die am Gehäuseteil 13 angreifende Anzeige- und Bedieneinrichtung 17 der Steuerungseinrichtung 10 nicht nur die Ausnehmung 16 der Tragstruktur 11, sondern vielmehr auch eine Ausnehmung 19 des Tragrahmens 18.

Der Montagerahmen 18 verfügt über mindestens zwei Verrastungsvorsprünge 20.

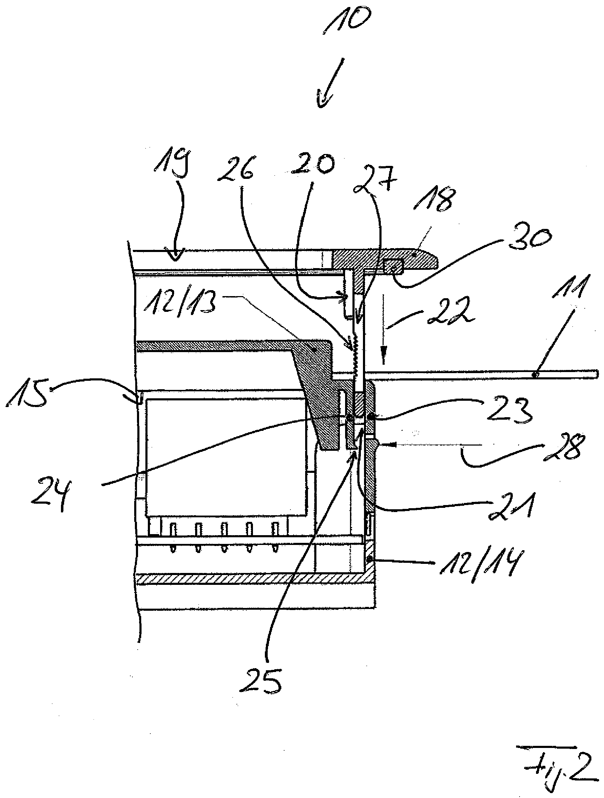

Bei der Befestigung des Gehäuses 12 an der Tragstruktur 11 sind die Verrastungsvorsprünge 20 in Ausnehmungen 21 des Gehäuses 12 einführbar. Fig. 2 zeigt einen Verrastungsvorsprung 20, der teilweise in eine Ausnehmung 21 des Gehäuses 12 eingeführt ist und im Sinne des Pfeils 22 weiter in diese Ausnehmung 21 eingeführt werden kann.

Jede Ausnehmung 21 des Gehäuses 12, in die ein Verrastungsvorsprung 20 einführbar ist, ist einerseits von einem Abschnitt einer Außenwand 23 des Gehäuses 12, nämlich des Gehäuseteils 13 des Gehäuses 12, und andererseits von einem elastisch verformbaren Steg 24 des Gehäuses 12, nämlich des Gehäuseteils 13 des Gehäuses 12, begrenzt. Dabei ragt der jeweilige elastisch verformbare Steg 24 in den Innenraum 15 des Gehäuses 12 hinein.

Der jeweilige elastisch verformbare Steg 24 des Gehäuses 12 weist eine in die jeweilige Ausnehmung 21 hineinragende, widerhakenartige Nase 25 auf. Dann, wenn der Montagerahmen 18 mit dem Gehäuse 12 der Steuerungseinrichtung 10 verrastet ist, greift die hakenartige Nase 25 eines jeden elastisch verformbaren Stegs 24 in eine profilierte Struktur 26 hinein, die an dem in die jeweilige Ausnehmung 25 eingeführten Verrastungsvorsprung 20 des Montagerahmens 18 ausgebildet ist.

Hierbei verrastet die Nase 25 des jeweiligen, elastisch verformbaren Stegs 24 des Gehäuses 12 mit der profilierten Struktur 26 des in die jeweilige Ausnehmung 21 eingeführten Verrastungsvorsprungs 20 des Montagerahmens 18.

Wie am besten Fig. 2 entnommen werden kann, sind die in die Ausnehmungen 21 hineinragenden, widerhakenartigen Nasen 25 der elastisch verformbaren Stege 24 dem Abschnitt der jeweiligen Außenwand 23 zugewandt, der mit dem jeweiligen Steg 24 die jeweilige Ausnehmung 21 begrenzt.

Dann, wenn der Montagerahmen 18 mit dem Gehäuse 12 verrastet ist, greifen die Nasen 25 in die jeweilige profilierte Struktur 26 des jeweiligen Verrastungsvorsprungs 20 des Montagerahmens 18 ein, wobei die profilierten Strukturen 26 der Verrastungsvorsprünge 20 an einer von der jeweiligen Außenwand 23 abgewandten Fläche des jeweiligen Verrastungsvorsprungs 20 ausgebildet sind.

Die Verrastungsvorsprünge 20 des Montagerahmens 18, die in die Ausnehmungen 21 des Gehäuses 12 der Steuerungseinrichtung 10 zur Befestigung derselben an der Tragstruktur 11 einführbar sind, verfügen über schlitzartige Ausnehmungen 27. Über diese schlitzartigen Ausnehmungen 27 sind zum Entfernen des Montagerahmens 18 vom Gehäuse 12 und damit zur Demontage der Steuerungseinrichtung 10 von der Tragstruktur 11 die elastisch verformbaren Stege 24 nach innen biegbar, um so die widerhakenartigen Nasen 25 der Stege 24 aus den profilierten Strukturen 26 der Verrastungsvorsprünge 20 des Montagerahmens 18 heraus zu bewegen. Dadurch kann die Verrastung zwischen Montagerahmen 18 und Gehäuse 12 aufgehoben werden, um den Montagerahmen 18 vom Gehäuse 12 abzuziehen und die im montierten Zustand mit den Stegen 24 verrasteten Verrastungsvorsprünge 20 des Montagerahmens 18 aus den Ausnehmungen 21 des Gehäuses 12 heraus zu bewegen.

Im Ausführungsbeispiel der Fig. 1 und 2 sind hierzu Abschnitte der Außenwand 23, welche die Ausnehmungen 21 zur Aufnahme der Verrastungsvorsprünge 20 des Montagerahmens 18 definieren, zumindest teilweise elastisch vorformbar ausgebildet, wobei dann, wenn die Verrastungsvorsprünge 20 des Montagerahmens 18 vollständig in die Ausnehmungen 21 des Gehäuses 12 eingeführt und mit den Stegen 24 verrastet sind, gemäß Fig. 2 diese Abschnitte der Außenwand 23 im Sinne des Pfeils 28 jeweils durch die jeweilige schlitzartige Ausnehmung 27 des Verrastungsvorsprungs 20 hindurch nach innen biegbar ist, um so den jeweiligen elastisch verformbaren Steg 24 zu kontaktieren und elastisch zu verformen, und um so letztendlich die Nase 25 desselben aus der profilierten Struktur 26 des jeweiligen Verrastungsvorsprungs 20 heraus zu bewegen und die Verrastung aufzuheben.

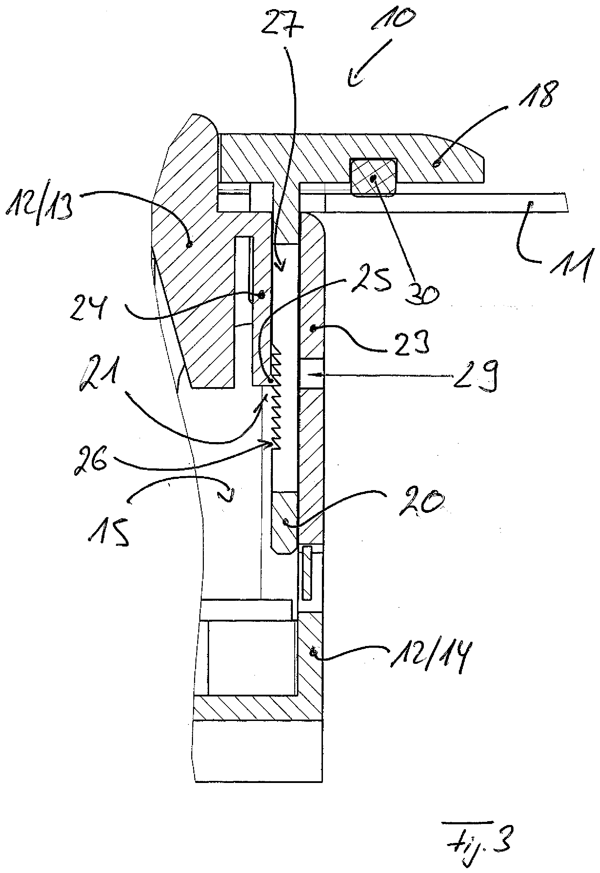

Fig. 3 zeigt ein Ausführungsbeispiel der Erfindung, in welchem die Außenwand 23 des Gehäuses 12, nämlich des Gehäuseteils 13, keine elastisch verformbaren Abschnitte aufweist. Vielmehr ist im Ausführungsbeispiel der Fig. 3 zur Aufhebung der Verrastung zwischen dem Montagerahmen 18 und dem Gehäuse 12 in die Außenwand 23 des Gehäuses 12 eine Öffnung 29 eingebracht, in die zum Beispiel ein Schraubenzieher einführbar ist, der sich durch die schlitzartige Ausnehmung 27 im jeweiligen Verrastungsvorsprung 20 des Montagerahmens 18 erstreckt und nach Kontaktierung des Stegs 24 denselben nach innen biegen kann, um die widerhakenartige Nase 25 des Stegs 24 aus der profilierten Struktur 26 heraus zu bewegen und so die Verrastung zwischen dem Montagerahmen 18 und dem Gehäuse 12, nämlich zwischen der Nase 25 des Stegs 24 und der profilierten Struktur 26 des Verrastungsvorsprungs 20, aufzuheben. In diesem Fall muss lediglich gewährleistet sein, dass im verrasteten Zustand des Montagerahmens 18 und des Gehäuses 12 der Steuerungseinrichtung 10 die Öffnung 29 in der Außenwand 23 des Gehäuses 12 abschnittsweise deckungsgleich mit der schlitzartigen Ausnehmung 27 des jeweiligen Verrastungsvorsprungs 20 des Montagerahmens 18 ist.

Es sei darauf hingewiesen, dass die Ausgestaltung der Fig. 1 und 2 bevorzugt ist, da in diesem Fall auch zur Demontage der Steuerungseinrichtung 10 von der Tragstruktur 11 kein Werkzeug erforderlich ist.

Dann, wenn der Tragrahmen 18 in dem Gehäuse 12 der Steuerungseinrichtung 10 verrastet ist, liegt ein dem Tragrahmen 18 zugeordnetes elastisches Dichtungselement 30 am Tragrahmen 11 an und sorgt für eine permanente Spannung der Verrastung, so dass diese federnde Wirkung einen sicheren Halt der Steuerungseinheit 10 gewährleistet. Gleichzeitig dient dieses Dichtungselement 30 als Spielausgleich zwischen den verschiedenen Wandstärken der Tragstruktur 11 und dem Montagerahmen 18.

### Bezugszeichenliste

- 10: Steuerungseinrichtung
- 11: Tragstruktur
- 12: Gehäuse
- 13: Gehäuseteil
- 14: Gehäuseteil
- 15: Innenraum
- 16: Öffnung
- 17: Anzeige- und Bedieneinrichtung
- 18: Montagerahmen
- 19: Öffnung
- 20: Verrastungsvorsprung
- 21: Ausnehmung
- 22: Pfeil
- 23: Außenwand
- 24: Steg
- 25: Nase
- 26: profilierte Struktur
- 27: Ausnehmung
- 28: Pfeil
- 29: Öffnung
- 30: elastisches Dichtungselement

## Patentansprüche

1. Steuerungseinrichtung, mit einem insbesondere elektrische und/oder elektronische Steuerungskomponenten aufnehmenden Gehäuse (12), und mit Befestigungsmitteln, über welche das Gehäuse (12) an einer Tragstruktur (11), insbesondere an einer Tragwand, montierbar ist, wobei ein Montagerahmen (18) die Befestigungsmittel bildet, der dann, wenn das Gehäuse (12) von einer ersten Seite der Tragstruktur aus in eine Öffnung in der Tragstruktur zumindest abschnittsweise eingesetzt ist, von einer gegenüberliegenden zweiten Seite der Tragstruktur aus mit dem Gehäuse (12) unter Befestigung desselben an der Tragstruktur verrastbar ist, **dadurch gekennzeichnet, dass** der Montagerahmen (18) mindestens zwei Verrastungsvorsprünge (20) aufweist, die bei der Befestigung des Gehäuses (12) an der Tragstruktur (11) in Ausnehmungen (21) des Gehäuses (12) einführbar sind, wobei jede Ausnehmung (21) des Gehäuses (12), in die ein Verrastungsvorsprung (20) des Montagerahmens (18) einführbar ist, einerseits von einem Abschnitt einer Außenwand (23) des Gehäuses (12) und andererseits von einem elastisch verformbaren Steg (24) des Gehäuses (12) begrenzt ist, wobei der jeweilige elastisch verformbaren Steg (24) des Gehäuses (12) eine in die jeweilige Ausnehmung (21) hineinragende, widerhakenartige Nase (25) aufweist, die dann, wenn der Montagerahmen (18) mit dem Gehäuse (12) verrastet ist, in eine profilierte Struktur (26), die an einem in die jeweilige Ausnehmung (21) eingeführten Verrastungsvorsprung (20) ausgebildet ist, eingreift und so mit derselben verrastet.

2. Steuerungseinrichtung nach Anspruch 1, **dadurch gekennzeichnet, dass** die elastisch verformbaren Stege (24) des Gehäuses (12), die zusammen mit den Abschnitten der Außenwand (23) desselben die Ausnehmungen (21) zur Aufnahme der Verrastungsvorsprünge (20) definieren, in einen Innenraum (15) des Gehäuses (12) hineinragen, wobei die in die Ausnehmungen (21) hineinragenden, widerhakenartigen Nasen (25) der elastisch verformbaren Stege (24) der jeweiligen Außenwand (23) zugewandt sind und dann, wenn der Montagerahmen (18) mit dem Gehäuse (12) verrastet ist, in die profilierte Struktur (26) des jeweiligen Verrastungsvorsprungs (20), die an einer von der jeweiligen Außenwand (23) abgewandten Fläche desselben ausgebildet ist, eingreifen.

3. Steuerungseinrichtung nach Anspruch 1 oder 2, **dadurch gekennzeichnet, dass** die Verrastungsvorsprünge (20) des Montagerahmens (18) schlitzartige Ausnehmungen (27) aufweisen.

4. Steuerungseinrichtung nach Anspruch 3, **dadurch gekennzeichnet, dass** durch die schlitzartigen Ausnehmungen (27) der Verrastungsvorsprünge (20) hindurch zum Entfernen des Montagerahmens (18) vom Gehäuse (12) die elastisch verformbaren Stege (24) nach innen biegbar und so die widerhakenartigen Nasen (25) der elastisch verformbaren Stege (24) aus den profilierten Strukturen (26) der Verrastungsvorsprünge (20) des Montagerahmens (18) heraus bewegbar sind.

5. Steuerungseinrichtung nach Anspruch 4, **dadurch gekennzeichnet, dass** hierzu die Abschnitte der Außenwand (23), welche die Ausnehmungen (21) zur Aufnahme der Verrastungsvorsprünge (20) definieren, zumindest teilweise elastisch verformbar sind.

6. Steuerungseinrichtung nach Anspruch 5, **dadurch gekennzeichnet, dass** die Abschnitte der Außenwand (23) nach innen durch die schlitzartige Ausnehmung (27) des jeweiligen Verrastungsvorsprungs (20) hindurch unter Kontaktierung und elastischer Verformung des jeweiligen elastisch verformbaren Stegs (24) des Gehäuses (12) biegbar sind.

## Claims

1. Control device comprising a housing (12) which accommodates, in particular, electrical and/or electronic control components, and comprising fastening means by means of which the housing (12) can be fitted to a supporting structure (11), in particular to a supporting wall, wherein a mounting frame (18) forms the fastening means, which mounting frame, when the housing (12) is inserted at least in sections from a first side of the supporting structure into an opening in the supporting structure, can be latched to the housing (12) from an opposite second side of the supporting structure with fastening of the said housing to the supporting structure, **characterized in that** the mounting frame (18) has at least two latching projections (20) which can be inserted into recesses (21) in the housing (12) when the housing (12) is fastened to the supporting structure (11), wherein each recess (21) of the housing (12), into which recess a latching projection (20) of the mounting frame (18) can be inserted, is delimited on one side by a section of an outer wall (23) of the housing (12) and on the other side by an elastically deformable web (24) of the housing (12), wherein the respective elastically deformable web (24) of the housing (12) has a barb-like lug (25) which projects into the respective recess (21) and which, when the mounting frame (18) is latched to the housing (12), engages into a profiled structure (26), which is formed on a latching projection (20) which is inserted into the respective recess (21), and in this way latches to the said profiled structure.

2. Control device according to Claim 1, **characterized in that** the elastically deformable webs (24) of the housing (12), which together with the sections of the outer wall (23) of the said housing define the recesses (21) for receiving the latching projections (20), protrude into an interior space (15) in the housing (12), wherein the barb-like lugs (25) which protrude into the recesses (21) face the elastically deformable webs (24) of the respective outer wall (23) and, when the mounting frame (18) is latched to the housing (12), engage into the profiled structure (26) of the respective latching projection (20) which is formed on a surface of the said housing which is averted from the respective outer wall (23).

3. Control device according to Claim 1 or 2, **characterized in that** the latching projections (20) of the mounting frame (18) have slot-like recesses (27).

4. Control device according to Claim 3, **characterized in that** the elastically deformable webs (24) can be bent inwards through the slot-like recesses (27) in the latching projections (20) in order to remove the mounting frame (18) from the housing (12), and in this way the barb-like lugs (25) of the elastically deformable webs (24) can be moved out of the profiled structures (26) of the latching projections (20) of the mounting frame (18).

5. Control device according to Claim 4, **characterized in that**, to this end, the sections of the outer wall (23), which define the recesses (21) for receiving the latching projections (20), are at least partially elastically deformable.

6. Control device according to Claim 5, **characterized in that** the sections of the outer wall (23) can be bent inwards through the slot-like recess (27) in the respective latching projection (20) so as to make contact with and elastically deform the respective elastically deformable web (24) of the housing (12).

## Revendications

1. Dispositif de commande, comportant un boîtier (12) dans lequel sont logés des composants de commande, en particulier électriques/ou électroniques, et comportant des moyens de fixation par l'intermédiaire desquels le boîtier (12) peut être monté sur une structure de support (11), en particulier sur une paroi de support, dans lequel un châssis de montage (18) forme les moyens de fixation, lequel châssis de montage ne peut être verrouillé que lorsque le boîtier (12) est inséré au moins par sections par une première face de la structure de support dans une ouverture ménagée dans la structure de support, depuis une seconde face opposée de la structure de support, avec le boîtier (12), par fixation de ce dernier à la structure de support, **caractérisé en ce que** le châssis de montage (18) comporte au moins deux protubérances de verrouillage (20) qui peuvent être introduites, lors de la fixation du boîtier (12) à la structure de support (11) dans des évidements (21) du boîtier (12), dans lequel chaque évidement (21) du boîtier (12), dans lequel peut être introduite une protubérance de verrouillage (20) du châssis de montage (18), est d'une part délimitée par une section d'une paroi extérieure (23) du boîtier (12) et d'autre part par une traverse (24) déformable élastiquement du boîtier (12), dans lequel la traverse (24) déformable élastiquement respective du boîtier (12) comporte un ergot (25) en forme de crochet faisant saillie à l'intérieur de l'évidement (21) respectif, qui ne s'engage dans une structure profilée (26) réalisée sur une protubérance de verrouillage (20) introduite dans l'évidement respectif (21) et par conséquent, ne se verrouille sur celui-ci, que lorsque le châssis de montage (18) est verrouillé su le boîtier (12).

2. Dispositif de commande selon la revendication 1, **caractérisé en ce que** la traverse (24) déformable élastiquement du boîtier (12), qui définit en association avec les sections de la paroi extérieure (23) de ce dernier les évidements (21) destinés à recevoir les protubérances de verrouillage (20), font saillie à l'intérieur d'un espace intérieur (15) du boîtier (12), dans lequel les ergots (25) en forme de crochets faisant saillie dans les évidements (21) des traverses déformables élastiquement (24) sont tournés vers la paroi extérieure (23) respective et ne s'engagent dans la structure profilée (26) de la protubérance de verrouillage (20), réalisée sur une surface de celle-ci qui est tournée à l'opposé de la paroi extérieure respective (23), que lorsque le châssis de montage (18) est verrouillé sur le boîtier (12) .

3. Dispositif de commande selon la revendication 1 ou 2, **caractérisé en ce que** les protubérances de verrouillage (20) du châssis de montage (18) présentent des évidements en forme de fentes (27).

4. Dispositif de commande selon la revendication 3, **caractérisé en ce que** les traverses déformables élastiquement (24) peuvent être incurvées vers l'intérieur et par conséquent, les ergots en forme de crochets (25) des traverses déformables élastiquement (24) peuvent être déplacés en dehors des structures profilées (26) des protubérances de verrouillage (20) du châssis de montage (18) à travers les évidements en forme de fentes (27) des protubérances de verrouillage (20) pour retirer le châssis de montage (18) du boîtier (12) .

5. Dispositif de commande selon la revendication 4, **caractérisé en ce que** les sections de la paroi extérieure (23) qui définissent les évidements (21) destinés à recevoir les protubérances de verrouillage (20) sont à cet effet déformables élastiquement au moins partiellement.

6. Dispositif de commande selon la revendication 5, **caractérisé en ce que** les sections de la paroi extérieure (23) peuvent être incurvées vers l'intérieur à travers l'évidement en forme de fente (27) de la protubérance de verrouillage respective (20) en venant au contact de la traverse déformable élastiquement (24) respective du boîtier (12) et en la déformant élastiquement.
